# EUROPEAN PATENT APPLICATION

(11) **EP 2 544 227 A1**
(43) Date of publication of application: **09.01.2013**
(21) Application number: 11172971.1
(22) Date of filing: 07.07.2011
(51) Int. Cl.: H01L 21/84, H01L 27/102, H01L 27/12, H01L 29/861, G11C 17/14, H01L 23/525, G11C 17/16

(54) **Non-volatile memory cell structure and method for programming and reading the same**

(71) Applicant: eMemory Technology Inc., Hsin-Chu 30075 (TW)
(72) Inventor: Chen, Hsin-Ming, 300 Hsinchu City (TW); Lu, Hau-Yan, 300 Hsinchu City (TW); Wang, Shih-Chen, Taipei City (TW); Yang, Ching-Sung, 300 Hsinchu City (TW)
(74) Representative: Becker Kurig Straus

(57) **Abstract**

The present invention provides a non-volatile memory cell structure. A first isolation structure (120) is disposed on a substrate (110) and a semiconductor layer (130) is disposed on the first isolation structure (120) to form a silicon on insulator device. A first doping region (131) is made of a portion of the semiconductor layer (130). A gate (140) is disposed on the first doping region (131). A gate oxide layer (141) is sandwiched between the first doping region (131) and the gate (140). A second doping region (135) is disposed within the semiconductor layer (130) and outside the first doping region (131). The second doping region (135) is in direct contact with the first doping region (131). A second isolation structure (150) is disposed on the first isolation structure (120). Further, the second isolation structure (150) surrounds the first doping region (131) and the second doping region (135). The second isolation structure (150) is also in direct contact with the first doping region (130) and the second doping region (135).
Heavily doped regions (132,136) can be provided inside doping regions 131 and 135.

## Description

### Field of the Invention

The present invention relates to a non-volatile memory cell structure of a silicon on insulator (SOI) device with no selection transistor therein as well as the method for using, such as programming and reading, the non-volatile memory cell structure of a silicon on insulator device with no selection transistor therein according to the pre-characterizing clauses of claims 1 and 7.

### Background of the Invention

There are various advantages of one time programmable (OTP) semiconductor memory using gate oxide breakdown. First, it is compatible with the CMOS production process, making it suitable for embedded memory integrated into a CMOS circuit/system. Second, it is very safe for the stored information security due to the fact that the oxide breakdown is the filament formation across the oxide regime. This filament formation is a kind of physical change but hard to use the available inspection tools to detect. Once the memory cell is programmed, it is nearly impossible for it to be erased by the optical (ultra-violet light erase) or other electrical means. It also implies that data in the oxide rupture non-volatile memory (NVM) memory is secured and not altered easily.

U.S. Pat. No. 6,956,258 discloses semiconductor memory cells each having a data storage element constructed around an ultra-thin dielectric such as a gate oxide. The gate oxide is used to store information by stressing the ultra-thin dielectric into breakdown (soft or hard breakdown) to set the leakage current level of the memory cell. However, such technology has some drawbacks. First, all cells share the same non-insulating substrate so the semiconductor memory cells are not electrically segregated and isolated. Accordingly, it is hard to activate a specific cell and to inhibit the neighboring cells at the same time in order to avoid interference. Second, there is a required selection transistor present in the semiconductor memory cell. This required selection transistor inevitably increases the complexity of the semiconductor memory cell's operation, the overhead of peripheral circuitry for controlling the memory cell's operation as well as the area of each unit cell.

U.S. Pat. No. 7,623,368 discloses a semiconductor memory structure based on gate oxide breakdown which is constructed in a deep N-well. Similarly, there is also a selection transistor present (also identified as a PASS transistor) in the semiconductor memory cell. This required selection transistor inevitably increases the complexity of the semiconductor memory cell's operation, the overhead of peripheral circuitry for controlling the memory cell's operation as well as the area of each unit cell.

U.S. Pat. No. 7,642,138 & 7,880,211 discloses anti-fuse memory cells having a variable thickness gate oxide. The variable thickness gate oxide has a thicker gate oxide portion and a thinner gate oxide portion, where the thinner gate oxide region acts as a localized breakdown voltage zone. This variable thickness gate oxide process increases the number of steps of the fabrication process (especially for a thick gate and a thin gate oxide formation), the complexity of the semiconductor memory cells, and the area of each unit cell. Second, a number of steps of the fabrication process must be modified to obtain the complicated gate oxide of variable thickness.

Recently, Ahn etc. disclosed an alternative kind of oxide rupture cell structure (with A1203 antifuse and p-CuOx/n-InZnOx diode, published in IEEE Electron Device Letters, Vo1.30, No.5, May 2009). The one-time-programmable memory cell is stackable All-Oxide-Based NVM cell. There is no selection transistor implemented in this memory cell. Ahn used diode selection architecture to select and un-select the memory cells. However, the oxide breakdown fuse element is additional process steps to conventional CMOS logic baseline and formed upon top of the CMOS logic devices. It is not fully compatible with the mainstream foundry process node.

Hence, a novel non-volatile memory cell structure is still needed to provide a non-volatile memory with better cell density. In addition, the novel non-volatile memory cells should have simpler structure and be electrically isolated from the neighboring cells to avoid any possible interference with other cells during operation, such as programming or reading. From the process integration point of view, the memory cell using front end device elements is preferred. Especially, in the Silicon on Insulator (SOI) process, very few ideas or inventions relate to implementation of a logic compatible OTP nonvolatile memory cell.

### Summary of the Invention

This in mind, the present invention aims at providing a non-volatile programmable memory cell structure formed on a Silicon On Insulator that **has** simpler structure and is electrically isolated from the neighboring cells.

This is achieved by a non-volatile programmable memory cell structure formed on a Silicon On Insulator according to claims 1 and 7. The dependent claims pertain to corresponding further developments and improvements.

The present invention as a result proposes a non-volatile memory cell structure and the method for using, such as programming and reading, the non-volatile memory cell structure. The non-volatile memory cell structure of the present invention has several advantageous features. First, the non-volatile memory cell is full process compatible with the available and existing SOI CMOS manufacturing steps. Second, the non-volatile memory cell structure of the present invention is a silicon on insulator device to ensure that every cell functions independently with minimized interference between neighborhood cells. Third, there is no need to have second gate oxide thickness due to that the gate oxide in the non-volatile memory cell structure of the present invention has a uniform thickness. Last but not least, the non-volatile memory cell structure of the present invention has no selection transistor therein.

In a first aspect of the present invention, a non-volatile memory cell structure is proposed. The non-volatile memory cell structure includes a substrate, a first isolation structure, a first doped Si-region (namely a first doping region), a gate, a gate oxide layer, a second doped Si-region (namely a second doping region) and a second isolation structure. The first isolation structure is disposed on the substrate. The first doping region is disposed on the first isolation structure so that the substrate, the first isolation structure and the first doping region together form a silicon on insulator device. The gate is disposed on the first doping region. The gate oxide layer is sandwiched between the first doping region and the gate. The second doping region is disposed on the first isolation structure. The second doping region is in direct contact with the first doping region. The second isolation structure is disposed on the first isolation structure. Further, the second isolation structure surrounds the first doping region and the second doping region. The second isolation structure is also in direct contact with the first doping region and the second doping region.

In a second aspect of the present invention, a method for programming a non-volatile memory cell is provided. First, a plurality of non-volatile memory cells is provided. One of the non-volatile memory cells is determined to be a target memory cell and includes a substrate, a first isolation structure, a first doping region, a gate, a gate oxide layer, a second doping region and a second isolation structure. The first isolation structure is disposed on the substrate. The first doping region is disposed on the first isolation structure so the substrate, the first isolation structure and the first doping region together form a silicon on insulator device. The gate is disposed on the first doping region. The gate oxide layer is sandwiched between the first doping region and the gate. The second doping region is disposed on the first isolation structure. The second doping region is in direct contact with the first doping region. The second isolation structure is disposed on the first isolation structure. Further, the second isolation structure surrounds the first doping region and the second doping region. The second isolation structure is also in direct contact with the first doping region and the second doping region. Second, the selected gates of the non-volatile memory cells are connected to a programming voltage (Vpp) and the unselected gates of the non-volatile memory cells are coupled to 1/2 of the programming voltage (1/2*Vpp). Then, the selected second doping regions of the non-volatile memory cells are connected to 0 Volt and the un-selected second doping regions of the nonvolatile memory cells are coupled to the programming voltage (Vpp). In this bias configuration, the cross-point of the selected gate line and the selected second doping region line is the target memory cell to be programmed. Its gate is connected to the programming voltage (Vpp) and its second doping region is connected to 0 volts.

In a third aspect of the present invention, another method for programming a non-volatile memory cell is provided. First, a plurality of non-volatile memory cells is provided. One of the non-volatile memory cells is determined to be a target memory cell and includes a substrate, a first isolation structure, a first doping region, a gate, a gate oxide layer, a second doping region and a second isolation structure. The first isolation structure is disposed on the substrate. The first doping region is disposed on the first isolation structure so the substrate, the first isolation structure and the first doping region together form a silicon on insulator device. The gate is disposed on the first doping region. The gate oxide layer is sandwiched between the first doping region and the gate. The second doping region is disposed on the first isolation structure. The second doping region is in direct contact with the first doping region. The second isolation structure is disposed on the first isolation structure. Further, the second isolation structure surrounds the first doping region and the second doping region. The second isolation structure is also in direct contact with the first doping region and the second doping region. Second, the selected gates of the non-volatile memory cells are connected to a programming voltage (Vpp) and the unselected gates of the non-volatile memory cells are coupled to 0 volts. Later, the selected second doping regions of the non-volatile memory cells are connected to 0 volt and the un-selected second doping regions of the nonvolatile memory cells are coupled to 1/2 of the programming voltage(1/2*Vpp). In this bias configuration, the cross-point of the selected gate line and the selected second doping region line is the target memory cell to be programmed.

In a fourth aspect of the present invention, a method for reading a non-volatile memory cell is provided. First, a plurality of non-volatile memory cells is provided. One of the non-volatile memory cells includes a substrate, a first isolation structure, a first doping region, a gate, a gate oxide layer, a second doping region and a second isolation structure. The first isolation structure is disposed on the substrate. The first doping region is disposed on the first isolation structure so the substrate, the first isolation structure and the first doping region together form a silicon on insulator device. The gate is disposed on the first doping region. The gate oxide layer is sandwiched between the first doping region and the gate. The second doping region is disposed on the first isolation structure. The second doping region is in direct contact with the first doping region. The second isolation structure is disposed on the first isolation structure. Further, the second isolation structure surrounds the first doping region and the second doping region. The second isolation structure is also in direct contact with the first doping region and the second doping region. Second, the selected gates of the non-volatile memory cells are connected to a standard voltage (VDD) and the unselected gates of the non-volatile memory cells are coupled to 0 volt. Afterwards, the selected second doping regions of the non-volatile memory cells are connected to 0 volt and the unselected second doping regions of the non-volatile memory cells are coupled to the standard voltage (VDD). In this bias configuration, the cross-point of the selected gate line and the selected second doping region line is the target memory cell to be read.

As will be seen more clearly from the detailed description following below, the claimed non-volatile programmable memory cell structure formed on a Silicon On Insulator includes a simpler structure that is electrically isolated from the neighboring cells.

### Brief Description of the Drawings

In the following, the invention is further illustrated by way of example, taking reference to the accompanying drawings thereof.
FIG. 1 illustrates an embodiment of the non-volatile memory cell structure of the present invention,
FIG. 2 illustrates a preferred embodiment of the present invention,
FIG. 3 illustrates a pair of equivalent circuits of the non-volatile memory cell structure of the present invention with an optional capacitor or an optional resistance,
FIGS. 4-5 illustrate the memory array of the present invention and the electric connection of multiple non-volatile memory cells in the memory array to word lines and to bit lines,
FIGS. 6-7 illustrate the method for programming a non-volatile memory cell of the present invention,
FIGS. 8 and 9 illustrate a top view of the memory array of the present invention.
FIGS. 10-11 illustrate another method for programming a non-volatile memory cell of the present invention, and
FIGS. 12-13 illustrate a method for reading a non-volatile memory cell of the present invention.

### Detailed Description

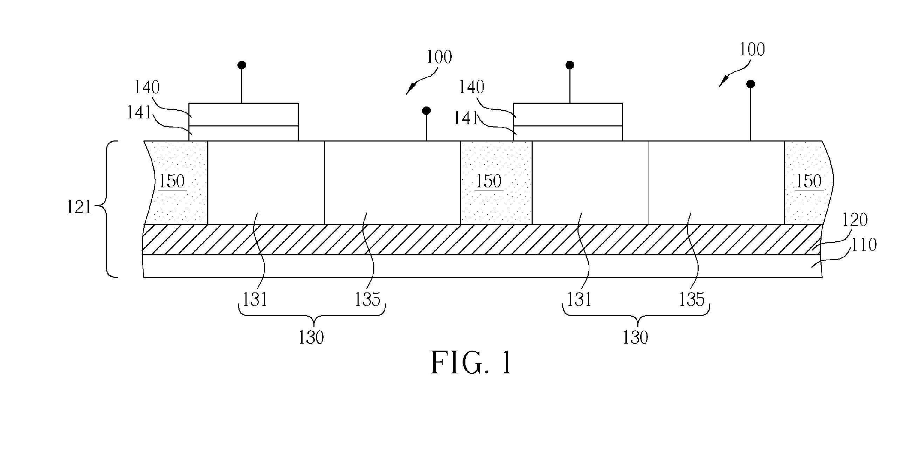

The present invention in a first aspect provides a non-volatile memory cell structure of anti-fusing type. FIG. 1 illustrates an embodiment of the non-volatile memory cell structure of the present invention. Please refer to FIG. 1, the non-volatile memory cell structure 100 of the present invention includes a substrate 110, a first isolation structure 120, a semiconductor layer 130, a first doping region 131, a gate 140, a gate oxide layer 141, a second doping region 135 and a second isolation structure 150.

The substrate 110 may include a semiconductor material, such as Si. The first isolation structure 120 may be an electrical insulator, such as a silicon dioxide or sapphire and is disposed on the substrate 110. The semiconductor layer 130 is disposed on the first isolation structure 120 and includes different doped semiconductor material, such as doped Si. The substrate 110, the first isolation structure 120 and the semiconductor layer 130 together form a silicon on insulator device 121.

The first doping region 131 and the second doping region 135 are respectively parts of the semiconductor layer 130 and in direct contact with each other. For example, the first doping region 131 is made of a portion of the semiconductor layer 130. The second doping region 135 is disposed within the semiconductor layer 130 and next to the first doping region 131.

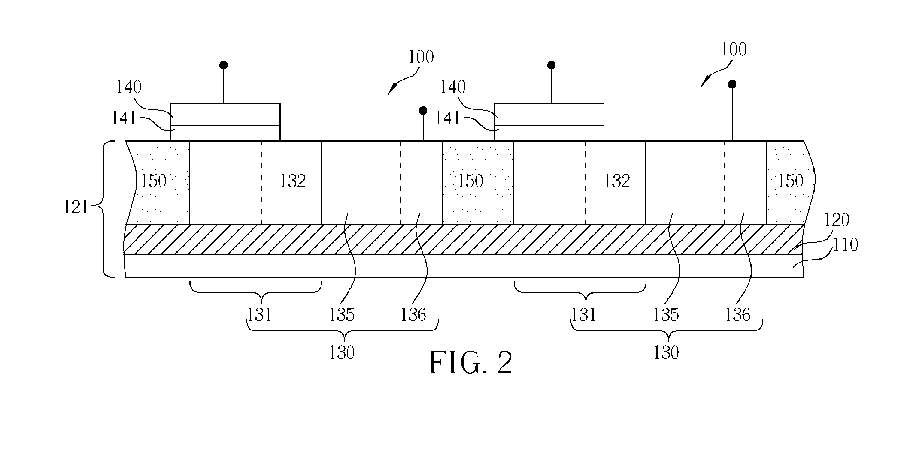

In one preferred embodiment of the present invention as shown in FIG. 2, the first doping region 131 may optionally include a first heavily doped region 132 which is in direct contact with the second doping region 135 so that the first heavily doped region 132 is disposed between the first doping region 131 and the second doping region 135. Besides, the second doping region 135 may also optionally include a second heavily doped region 136 which is in direct contact with the second isolation structure 150. In other words, the second heavily doped region 136 is surrounded by the second doping region 135 and the second isolation structure 150.

The gate 140 can be formed by doped polysilicon. The impurity type of the gate polysilicon can be the same as the first heavily doped region 132. A feasible way to implement the first heavily doped region 132 is to use the mask definition and implant the same dopants into the memory cell gate polysilicon and the first heavily doped region 132 at the implantation process step.

In another preferred embodiment of the present invention, the first doping region 131 and the second doping region 135 with the first heavily doped region 132 or the second heavily doped region 136 may together optionally form a gradient doping concentration. This majorly elevates the P-N junction breakdown by a gradient doping concentration profiles and lowers the connecting resistance by the heavier doping concentration simultaneously.

The gate 140 is disposed on the first doping region 131 and covers the first doping region 131. If there is the first heavily doped region 132, the gate 140 may fully overlay the first doping region 131 but partially and laterally overlay the first heavily doped region 132. In other words, the gate 140 may overlay the first doping region 131 and partially the first heavily doped region 132. However, the gate 140 does not cover the second doping region 135.

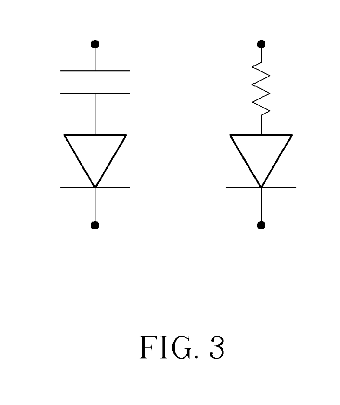

On one hand, the gate oxide layer 141 is sandwiched between the first doping region 131 and the gate 140 so that the first doping region 131, the gate oxide layer 141 and the gate 140 may together form an optional capacitor or an optional electric resistance based on the nonvolatile memory cell is programmed or not. On the other hand, the first doping region 131 and the second doping region 135 which are adjacent to each other together form a P-N junction (diode) to allow an only one direction of current flow. It means the reverse direction of current flow will be blocked but allow a forward current flow. The border of the first doping region 131 and the second doping region 135 lies across each semiconductor layer 130 so as to form at least one P-N junction in each semiconductor layer 130. The second doping region 135 is N type if the first doping region 131 is P type. The second doping region 135 is P type if the first doping region 131 is N type. FIG. 3 illustrates a pair of equivalent circuits of the non-volatile memory cell structure 100 of the present invention with an optional capacitor or an optional resistance in series with a diode based on the nonvolatile memory cell is programmed or not.

The non-volatile programmable memory cell is basically a one-time-programmable memory cell. The programming mechanism uses the high electrical field between the gate 140 and the first doping region 131 to breakdown the gate oxide layer 141. Usually, this is an anti-fusing type non-volatile memory cell. There is no current flow in the non-programmed gate oxide. After dedicated high voltage oxide breakdown mechanism (called programming process), the current starts flowing through the gate oxide 141 region. This is due to the filament path forming by high electrical field oxide rupture process.

If the nonvolatile memory cell is programmed, the non-volatile memory cell structure 100 exhibits a resistor in series with a diode. On the other hand, if the nonvolatile memory cell is not programmed yet, the non-volatile memory cell structure 100 exhibits the ideal capacitor in series with a diode.

The second isolation structure 150 is disposed on the first isolation structure 120. For example, the second isolation structure 150 may be a Shallow Trench Isolation (STI), or other field isolations. Further, the second isolation structure 150 usually entirely surrounds the first doping region 131, the optional first heavily doped region 132, the second doping region 135 and the optional second heavily doped region 136 to almost define the surface area of the non-volatile memory cell structure 100. The second isolation structure 150 is also in direct contact with the first doping region 131 and the second doping region 135 (FIG.1) so that each adjacent non-volatile memory cell structure 100 is well segregated and physically or electrically isolated by means of both the first isolation structure 120 and the second isolation structure 150 altogether.

Please note that there is no selection transistor needed or present in the non-volatile memory cell structure 100 of the present invention. In other words, one of the advantageous features of the non-volatile memory cell structure 100 of the present invention resides in omitting the conventional selection transistor. Once the conventional selection transistor is omitted, simple operation schemes are needed to operate the non-volatile memory cell structure 100 of the present invention. Apart from this advantage, with no traditional selection transistor present, the unit cell size becomes smaller and there is more surface area available for the elements in the non-volatile memory cell structure 100 of the present invention so the cell integration can be more compact and memory density of the non-volatile memory cell structure 100 of the present invention may accordingly get much higher.

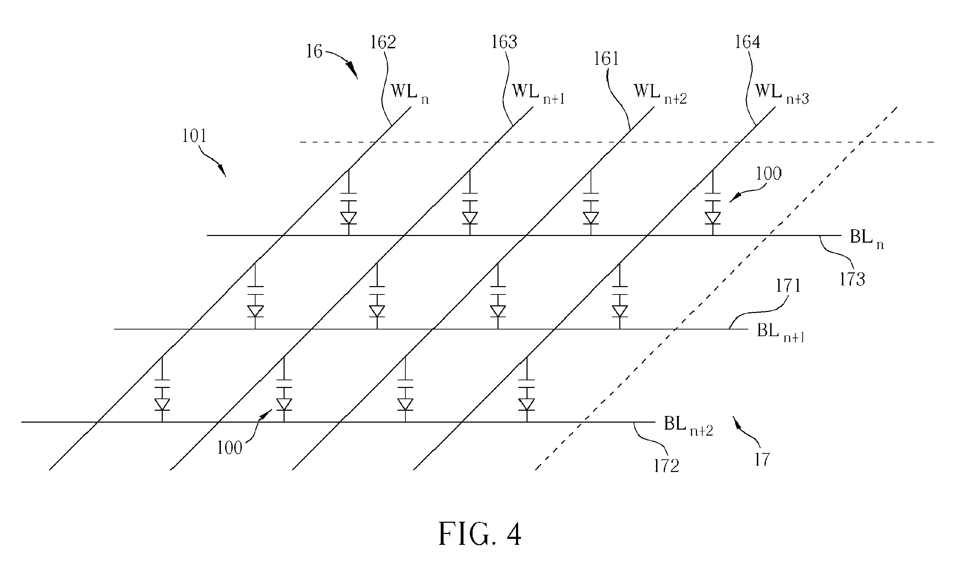

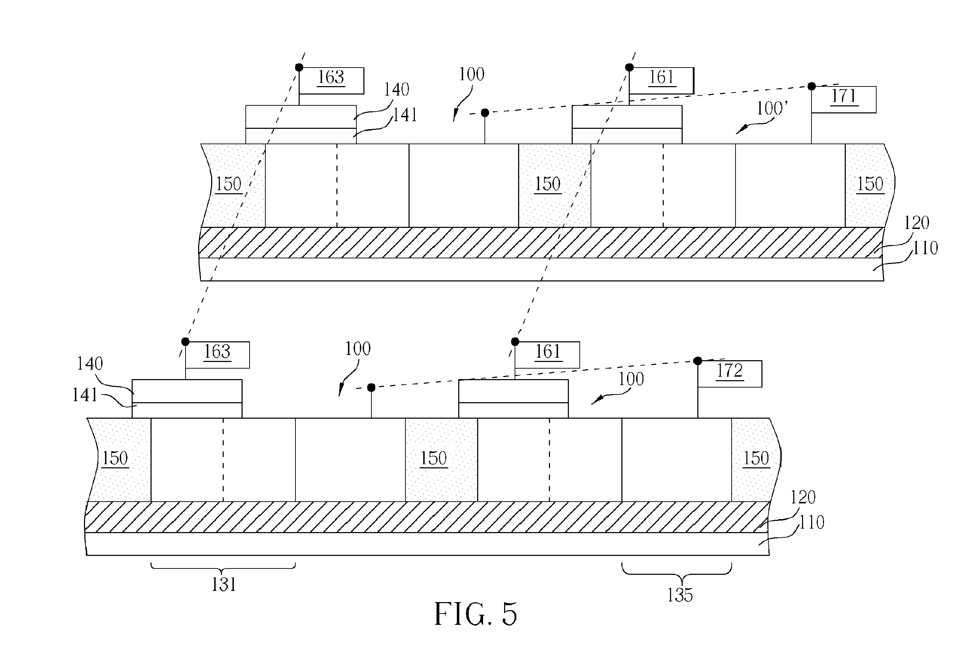

Consequently, please refer to FIGS. 4-5, illustrating the memory array 101 of the present invention and the electric connection of multiple non-volatile memory cells in the memory array to word lines and to bit lines. As shown in FIG. 4, multiple non-volatile memory cells 100 of the present invention, multiple word lines 16 and multiple bit lines 17 are arranged together to form a memory array 101 of the present invention. One non-volatile memory cell 100 is electrically connected to a specific word line 161 and a specific bit line 171 (for example). Other non-volatile memory cells are electrically connected to other word lines 162/163/164 and bit lines 172/173 (for example). As illustrated in both FIGS. 4-5, the memory array 101 of the present invention has a very uniform cell layout and floor plan, which is one of the features of the present invention.

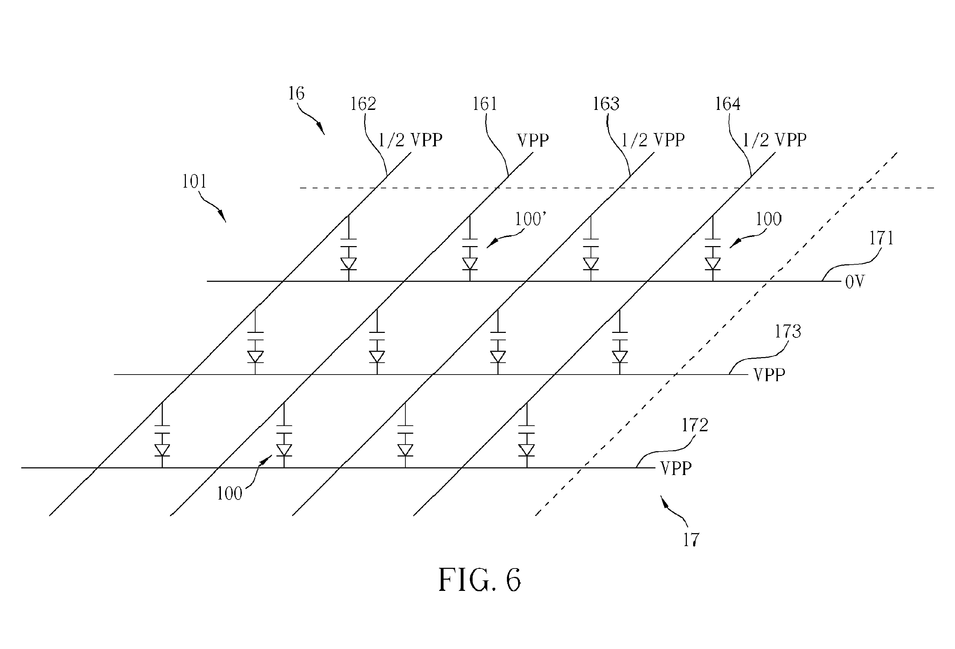

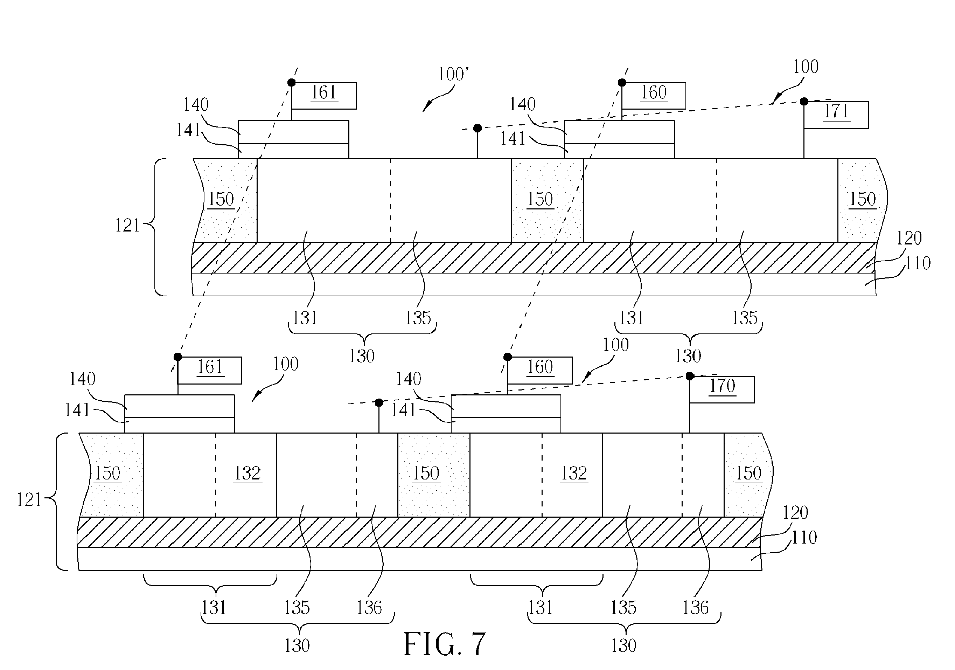

In a second aspect of the present invention, a method for programming a non-volatile memory cell is provided. FIGS. 6-7 illustrate the methods for programming a non-volatile memory cell of the present invention. First, as shown in FIG. 6, a plurality of non-volatile memory cells 100 are provided and multiple word lines 16 and multiple bit lines 17 are arranged together. One of the non-volatile memory cells 100 is determined to be a target memory cell to be programmed. The non-volatile memory cell 100' is taken for example for the target memory cell. As shown in FIG. 7, the non-volatile memory cell 100' includes a substrate 110, a first isolation structure 120, a semiconductor layer 130, a first doping region 131, a gate 140, a gate oxide layer 141, a second doping region 135 and a second isolation structure 150. The unselected gate 140 of the non-volatile memory cell 100 is electrically coupled to one of the word lines 162/163/164. Similarly, the second doping region 135 of the unselected non-volatile memory cell 100 is electrically coupled to one of the bit lines 172/173. The selected gate 140 of non-volatile memory cell 100' is electrically coupled to one of the word lines 161. Similarly, the second doping region 135 of unselected non-volatile memory cell 100' is electrically connected to one of the bit lines 171. The unselected non-volatile memory cells 100, the selected non-volatile memory cell 100', the multiple word lines 16 and multiple bit lines 17 together form the memory array 101. Please refer to FIGS. 1 and 2 for the detailed descriptions of the substrate 110, the first isolation structure 120, the semiconductor layer 130, the first doping region 131, the gate 140, the gate oxide layer 141, the second doping region 135 and the second isolation structure 150.

Optionally, in one preferred embodiment of the present invention as shown in FIG. 7, the first doping region 131 may optionally include a first heavily doped region 132 which is in direct contact with the second doping region 135 so that the first heavily doped region 132 is disposed between the first doping region 131 and the second doping region 135. Besides, the second doping region 135 may also optionally include a second heavily doped region 136 which is in direct contact with the second isolation structure 150 so that the second heavily doped region 136 is disposed between the second doping region 135 and the second isolation structure 150.

Second, during programming, the unselected gates 140 of the non-volatile memory cells 100 are electrically coupled to a programming voltage (Vpp) or 1/2 of the programming voltage. The selected gate 140 of the target memory cell 100' which is to be programmed is electrically connected to the programming voltage (Vpp, selected word line WL), and the rest of the non-volatile memory cells 100 that are not to be programmed are electrically connected to half of the programming voltage (1/2 *Vpp).The programming voltage (Vpp) for use to program the target memory cell 100' is optionally variable, principally dependent upon the thickness of the gate oxide layer 141. For example, if the gate oxide layer 141 is as thick as 125Å in a 6V device, the operational programming voltage (Vpp) may be up to more than 25-30V. On the other hand, if the gate oxide layer 141 is about as thin as 20Å in deep sub-micron process (for example, 45nm process), the operational programming voltage (Vpp) may be as low as 5-7V for example.

Then, the second doping region 135 of the non-volatile memory cells 100 are connected to the programming voltage (Vpp) or 0V. The target memory cell 100' to operate the programming functionality is electrically connected to 0V (selected Bit line BL) to form a programming voltage difference (Vpp, between WL and BL), and the rest word lines of the non-volatile memory cells 100 that do not undergo the programming operation are electrically connected to half of the programming voltage (1/2*Vpp). In this arrangement, the un-selected memory cells 100 will guarantee the voltage difference across the gate oxide 141 will not exceed the 1/2*Vpp and no programming operation applied to un-selected memory cells 100 thereafter. This method is carried out by the same bit line and selected by changing the parameters of different word lines.

Later, the target memory cell 100' is exclusively programmed since merely the target memory cell 100' has a sufficient bias difference (Vpp) between the two terminals of the memory cell 100' and the rest of the non-volatile memory cells 100 have no voltage drop or less than 1/2*Vpp which cannot initiate the oxide rupture process. This is because the gate 140 of the target memory cell 100' is connected to the programming voltage (Vpp) and its second doping region 135 is connected to 0 volt.

A sufficient programming voltage (Vpp) drop applied on the target memory cell 100' eventually breaks down its gate oxide layer 141, which turns the target memory cell 100' of capacitor type (intact) to an electric resistance type (break down), as shown in FIG. 3. The physical and electric property changes of the target memory cell 100' allow data to be stored permanently.

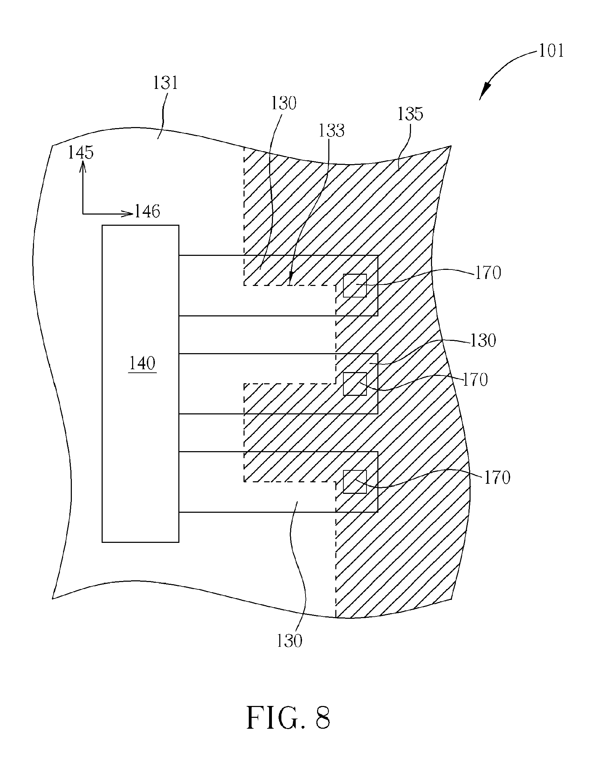

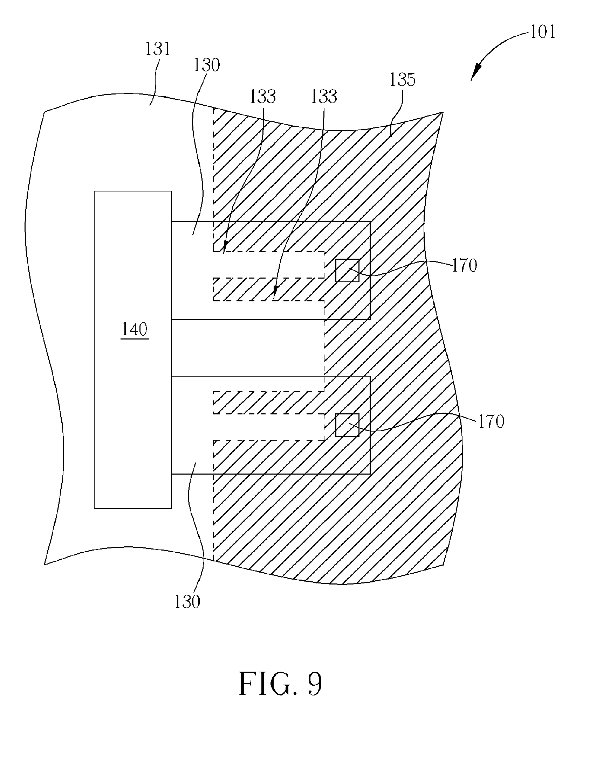

In still another preferred embodiment of the present invention, the first doping region 131 and the second doping region 135 in the non-volatile memory cells 100 may have a modified layout if the programming voltage (Vpp) for use to program the target memory cell 100' is so high and is possible to break down the P-N junction within the non-volatile memory cells 100. FIGS. 8 and 9 illustrate a top view of the memory array of the present invention. As shown in FIG. 8, the memory array 101 includes a gate 140 and several independent semiconductor layers 130 directly contacting the gate 140. The end of each semiconductor layer 130 is electrically connected to the bit line 170. Each semiconductor layer 130 in the memory array 101 is divided into two doping region, namely the first doping region 131 and the second doping region 135. The border of the first doping region 131 and the second doping region 135 lies across each semiconductor layer 130 so as to form at least one P-N junction 133 in each semiconductor layer 130. This P-N junction is formed not only in parallel (direction 145) to but also in perpendicular (direction 146) to the direction of the gate 140. FIG. 8 illustrates that each semiconductor layer 130 has only one pair of P-N junctions 133 in view by the parallel direction to the gate 140.

This arrangement can form a super-junction within the semiconductor layer 130. A super-junction in each semiconductor layer 130 can effectively avoid the P-N junction within the non-volatile memory cells 100 breaking down once the programming voltage (Vpp) for use to program the memory cell 100 is too high. If necessary, each semiconductor layer 130 may have more than one pair of P-N junctions (in view by the parallel direction to the gate 140), i.e. multiple super-junctions 133 within each semiconductor layer 130 to more effectively avoid the P-N junction within the non-volatile memory cells 100 breaking down once the programming voltage (Vpp) for use to program the memory cell 100 is too high, as shown in FIG. 9.

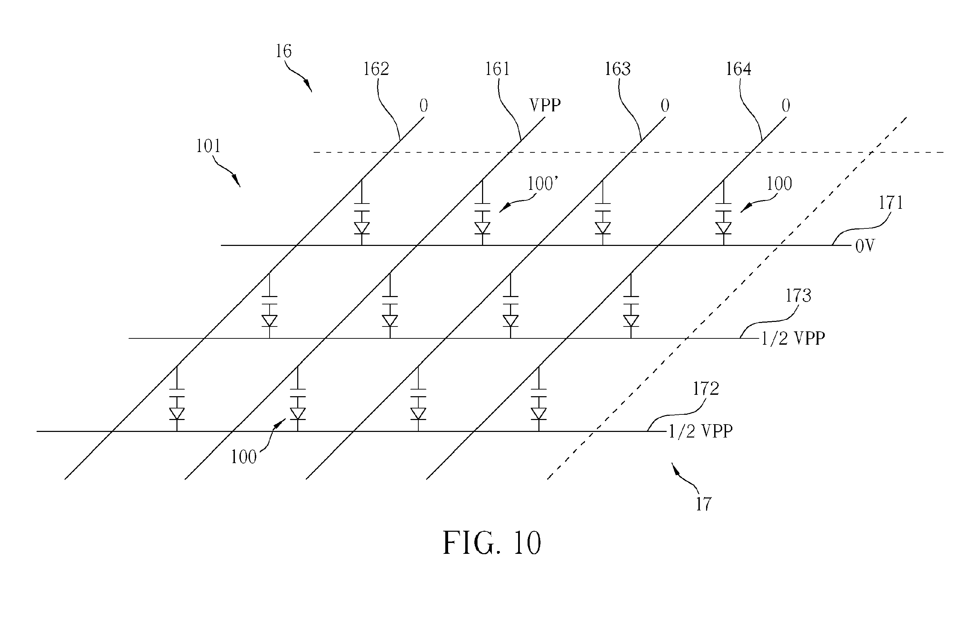

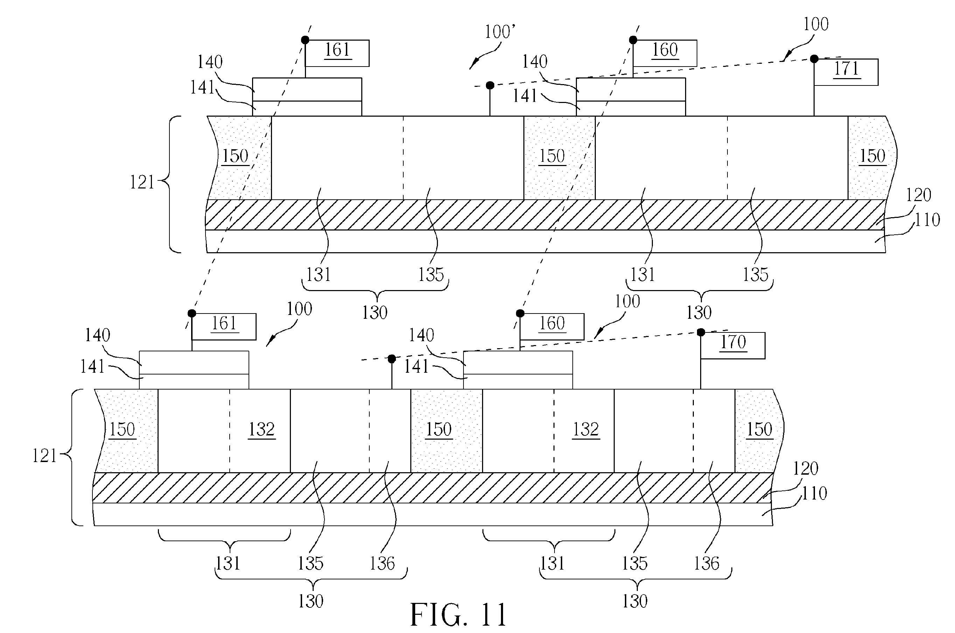

In a third aspect of the present invention, the present invention also provides another possible method for programming a non-volatile memory cell. FIGS. 10-11 illustrate another method for programming a non-volatile memory cell of the present invention. First, as shown in FIG. 10, a plurality of non-volatile memory cells 100 are provided and multiple word lines 16 and multiple bit lines 17 are arranged together. One of the non-volatile memory cells 100 is determined to be a target memory cell to be programmed. The non-volatile memory cell 100' is taken for example for the target memory cell. As shown in FIG. 11, the non-volatile memory cell 100' includes a substrate 110, a first isolation structure 120, a semiconductor layer 130, a first doping region 131, a gate 140, a gate oxide layer 141, a second doping region 135 and a second isolation structure 150. The unselected gate 140 of non-volatile memory cells 100 is electrically coupled to one of the word lines 162/163/164. Similarly, the second doping region 135 of unselected non-volatile memory cell 100 is electrically coupled to one of the bit lines 172/173. The selected gate 140 of non-volatile memory cell 100' is electrically coupled to one of the word lines 161. Similarly, the second doping region 135 of unselected non-volatile memory cell 100' is electrically connected to one of the bit lines 171. The non-volatile memory cells 100, the multiple word lines 16 and multiple bit lines 17 together form the memory array 101. Please refer to FIGS. 1 and 2 for the detailed descriptions of the substrate 110, the first isolation structure 120, the semiconductor layer 130, the first doping region 131, the gate 140, the gate oxide layer 141, the second doping region 135 and the second isolation structure 150.

Optionally, in one preferred embodiment of the present invention as shown in FIG. 11, the first doping region 131 may include a first heavily doped region 132 which is in direct contact with the second doping region 135 so that the first heavily doped region 132 is disposed between the first doping region 131 and the second doping region 135. Besides, the second doping region 135 may optionally include a second heavily doped region 136 which is in direct contact with the second isolation structure 150 so that the second heavily doped region 136 is disposed between the second doping region 135 and the second isolation structure 150.

Second, please refer to FIG. 10, the unselected gates 140 of the non-volatile memory cells 100 are electrically coupled to a programming voltage (Vpp) or 0 volts. The word line of target memory cell 100' is electrically connected to the programming voltage (Vpp, selected word line WL), and the rest word lines of the non-volatile memory cells 100 are electrically connected to 0 volts (or in another embodiment, electrically connected to 1/2*Vpp possibly).

The programming voltage (Vpp) for use to program the target memory cell 100' is optionally variable, principally dependent upon the thickness of the gate oxide layer 141. For example, if the gate oxide layer 141 is as thick as 125Å in a 6V device, the operational programming voltage (Vpp) may be up to more than 25-30V. On the other hand, if the gate oxide layer 141 is approximately as thin as 20Å in deep sub-micron process (for example, 45nm process), the operational programming voltage (Vpp) may be as low as 5-7V for example.

Then, the second doping regions 135 of the non-volatile memory cells 100 are coupled to half of the programming voltage (1/2*Vpp, selected Bit line, BL) or 0V The bit line of the target memory cell 100' is electrically connected to 0V to form a programming voltage difference (Vpp, between WL and BL), and the rest bit lines of the non-volatile memory cells 100 are electrically coupled to half of the programming voltage (1/2*Vpp). This method is carried out by the same word line and selected by changing the parameters of different bit lines.

Later, as shown in FIG. 10, the target memory cell 100' is exclusively programmed since the target memory cell 100' has a total programming voltage (Vpp) drop and the rest of the non-volatile memory cells 100 have only half of programming voltage (1/2*Vpp) drop because the gate 140 of the target memory cell 100' is electrically connected to the programming voltage (Vpp) and its second doping region 135 is electrically connected to 0 volts.

A sufficient programming voltage (Vpp) drop applied on the target memory cell 100' eventually breaks down its gate oxide layer 141, which turns the target memory cell 100' of capacitor type (intact) to an electric resistance type (break down), as shown in FIG. 3. The physical and electric property changes of the target memory cell 100' allow data to be stored permanently.

In still another preferred embodiment of the present invention, the first doping region 131 and the second doping region 135 in the non-volatile memory cells 100 may have a modified layout if the programming voltage (Vpp) for use to program the target memory cell 100' is so high and is possible to break down the P-N junction within the non-volatile memory cells 100. FIGS. 8 and 9 illustrate a top view of the memory array of the present invention. As shown in FIG. 8, the memory array 101 includes a gate 140 and several independent semiconductor layers 130 directly contacting the gate 140. The end of each semiconductor layer 130 is electrically connected to the bit line 170. Each semiconductor layer 130 in the memory array 101 is divided into two doping region, namely the first doping region 131 and the second doping region 135. The border of the first doping region 131 and the second doping region 135 lies across each semiconductor layer 130 so as to form at least one P-N junction 133 in each semiconductor layer 130. This P-N junction is formed not only in parallel to but also in perpendicular to the direction of the gate 140. FIG. 8 illustrates that each semiconductor layer 130 has only one pair of at least one P-N junction in view by the parallel direction to the gate 140.

This arrangement can form a super-junction within the semiconductor layer 130. A super-junction in each semiconductor layer 130 can effectively avoid the P-N junction within the non-volatile memory cells 100 breaking down once the programming voltage (Vpp) for use to program the target memory cell 100' is too high. If necessary, each semiconductor layer 130 may have more than one pair of P-N junctions 133 (in view by the parallel direction to the gate 140), i.e. multiple super-junctions 133 within each semiconductor layer 130, to more effectively avoid the P-N junction within the non-volatile memory cells 100 breaking down once the programming voltage (Vpp) for use to program the target memory cell 100' is too high, as shown in FIG. 9.

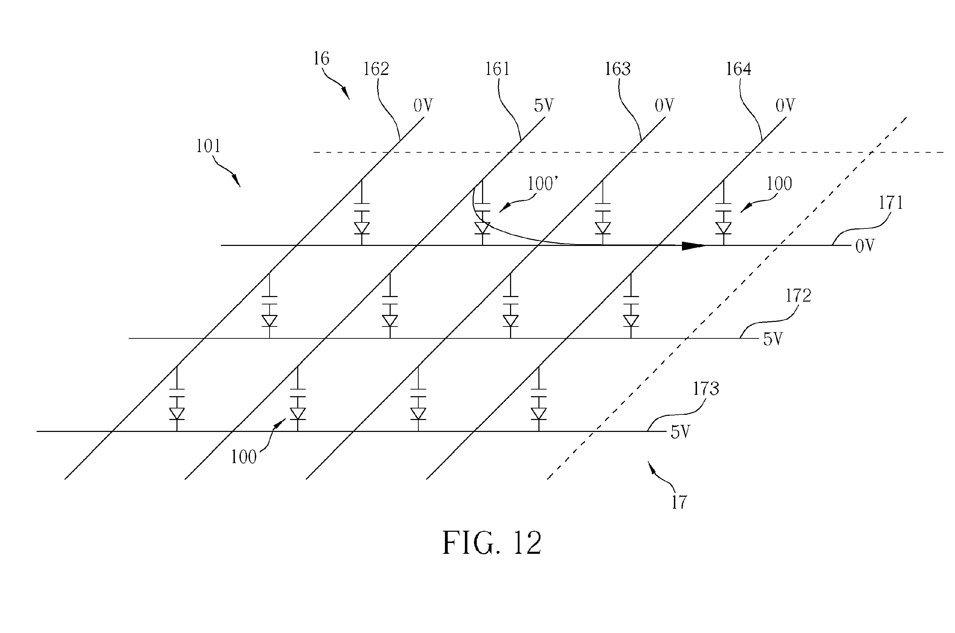

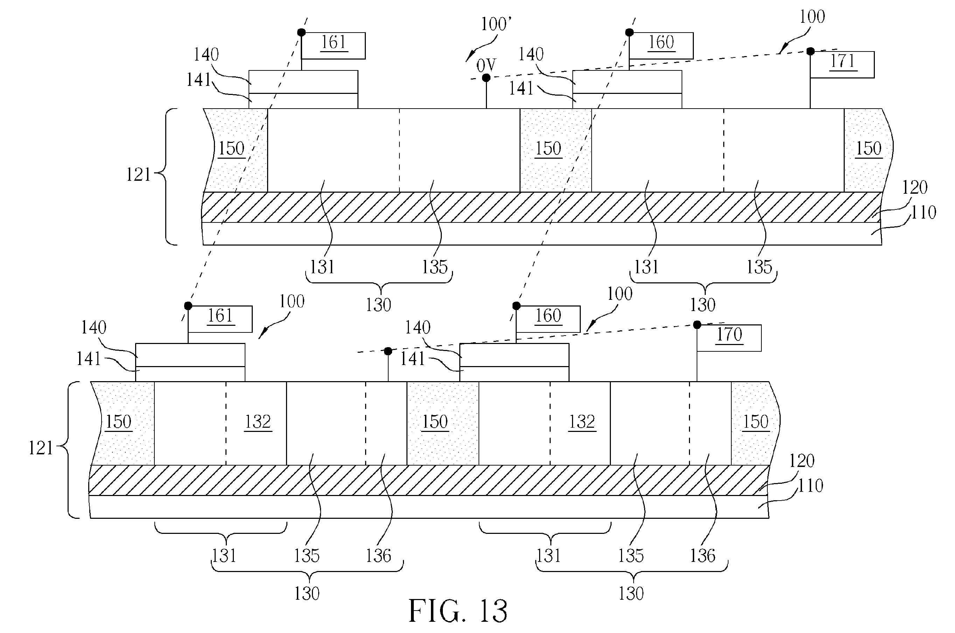

In a fourth aspect of the present invention, a method for reading a non-volatile memory cell is provided. FIGS. 12-13 illustrate a method for reading a non-volatile memory cell of the present invention. First, as shown in FIG. 12, a plurality of non-volatile memory cells 100 are provided. As shown in FIG. 13, the non-volatile memory cells 100 includes a substrate 110, a first isolation structure 120, a semiconductor layer 130, a first doping region 131, a gate 140, a gate oxide layer 141, a second doping region 135 and a second isolation structure 150. The unselected gate 140 of non-volatile memory cell 100 is electrically coupled to one of the word lines 162/163/164. Similarly, the second doping region 135 of unselected non-volatile memory cell 100 is electrically connected to one of the bit lines 172/173. The selected gate 140 of non-volatile memory cell 100' is electrically coupled to one of the word lines 161. Similarly, the second doping region 135 of unselected non-volatile memory cell 100' is electrically connected to one of the bit lines 171. The non-volatile memory cells 100, the multiple word lines 16 and multiple bit lines 17 together form the memory array 101. Please refer to FIGS. 1 and 2 for the detailed descriptions of the substrate 110, the first isolation structure 120, the semiconductor layer 130, the first doping region 131, the gate 140, the gate oxide layer 141, the second doping region 135 and the second isolation structure 150.

Second, the unselected gates 140 of the non-volatile memory cells 100 are coupled to one of a standard voltage (VDD) and 0 volts. The VDD is the standard voltage source applied on chips, 5V for example. The rest of the non-volatile memory cells 100 are electrically connected to 0 volts.

Afterwards, the second doping regions 135 of unselected non-volatile memory cells 100 are coupled to one of the standard voltage (VDD) or 0 volts. Then, the reading operation is carried on the non-volatile memory cell 100' whose gate is connected to the standard voltage (VDD) and whose second doping region is connected to 0 volts. The standard voltage (VDD) is sufficient to read data from the memory cells but is not high enough to break down the capacitor dielectric layer 141 at this voltage.

If there is a significant current to be detected, the specific non-volatile memory cell 100' has been programmed. Alternatively, the specific non-volatile memory cell 100' has not been programmed if there is no significant current which can be detected. In other words, only if the specific non-volatile memory cell 100' is programmed, significant current flow can be detected, otherwise the specific non-volatile memory cell 100' is not programmed.

Once programmed, on one hand a certain memory cell 100' transforms from a capacitor type to an electric resistance type owing to the break-down of its gate oxide layer 141. Since the capacitor dielectric layer 141 is damaged, a conductive path is therefore constructed and the first doping region 131, the gate oxide layer 141 and the gate 140 now together serve as an electric resistance. On the other hand, the first doping region 131 and the second doping region 135 together serve as a diode to allow a one direction current. This means the diode can serve the selection functionality and block the unselect current flow even in the unselected programmed cell. In the light of this, there is no current to be detected on other non-volatile memory cells 100 even though there is still a voltage drop present.

For completeness, further various aspects of the invention are set out in the following numbered clauses:
Clause 1: A method for programming a non-volatile memory cell, comprising:
   providing a plurality of non-volatile memory cells, one of said non-volatile memory cells comprising:
      a substrate;
      a first isolation structure on said substrate;
      a first doping region disposed on said first isolation structure;
      a gate disposed on said first doping region;
      a gate oxide layer sandwiched between said first doping region and said gate;
      a second doping region disposed on said first isolation structure, said second doping region being in direct contact with said first doping region and forming a p-n junction with said first doping region; and
      a second isolation structure disposed on said first isolation structure, surrounding said first doping region and said second doping region, and said second isolation structure being in direct contact with said first doping region and said second doping region, wherein one of said non-volatile memory cells is determined to be a target memory cell; and
   programming said target memory cell whose said gate is connected to said programming voltage (Vpp) and whose said second doping region is connected to 0 volts.
Clause 2: The method for programming a non-volatile memory cell of Clause 1, further comprising:
   connecting said gates of said non-volatile memory cells other than said target
      memory cell to the voltage smaller than said programming voltage (Vpp);
      and
   connecting said second doping regions of said non-volatile memory cells other than said target memory cell to the voltage smaller than said programming voltage.
Clause 3: The method for programming a non-volatile memory cell of Clause 1, wherein said target memory cell is programmed from comprising a capacitor to comprising an electric resistance by breaking down its gate oxide layer.
Clause 4: The method for programming a non-volatile memory cell of Clause 1, wherein said second doping regions of said non-volatile memory cells are connected to bit lines and said gates of said non-volatile memory cells are connected to word lines.
Clause 5: The method for programming a non-volatile memory cell of Clause 1, wherein said second doping region is N type if said first doping region is P type.
Clause 6: A method for reading a non-volatile memory cell, comprising:
   providing a plurality of non-volatile memory cells, one of said non-volatile memory cells comprising:
      a substrate;
      a first isolation structure on said substrate;
      a first doping region on said first isolation structure;
      a gate disposed on said first doping region;
      a gate oxide layer sandwiched between said first doping region and said
         gate;
      a second doping region disposed on said first isolation structure, said
         second doping region being in direct contact with said first doping region; and
      a second isolation structure disposed on said first isolation structure,
         surrounding said first doping region and said second doping region, and said second isolation structure being in direct contact with said first doping region and said second doping region and forming a p-n junction with said first doping region; and
   reading said non-volatile memory cell whose said gate is connected to said standard
      voltage (VDD) and whose said second doping region is connected to 0 volts.
Clause 7: The method for reading a non-volatile memory cell of claim Clause 6 further comprising:
   connecting said gates of said non-volatile memory cells other than said target
      memory cell to the voltage smaller than said standard voltage (VDD); and
   connecting said second doping regions of said non-volatile memory cells to the voltage smaller than said standard voltage (VDD).
Clause 8: The method for reading a non-volatile memory cell of Clause 6, wherein determining said non-volatile memory cell to be programmed is done by detecting a current.
Clause 9: The method for reading a non-volatile memory cell of Clause 6, wherein said second doping region is N type if said first doping region is P type.

## Claims

1. Anon-volatile programmable memory cell structure formed on a Silicon On Insulator, **characterized by**:
a substrate (110);
a first isolation structure (120) on said substrate (110);
a first doping region (131) disposed on said first isolation structure (120);
a gate (140) disposed on said first doping region (131);
a gate oxide layer (141) sandwiched between said first doping region (131) and said gate (140);
a second doping region (135) disposed on said first isolation structure (120), said
second doping region (135) being in direct contact with said first doping region (131) and forming a p-n junction with said first doping region (131); and
a second isolation structure (150) disposed on said first isolation structure (120),
surrounding said first doping region (131) and said second doping region (135), and said second isolation structure (150) being in direct contact with said first doping region (131) and said second doping region (135).

2. The non-volatile memory cell structure of claim 1 further **characterized in that** said second doping region (135) is N type if said first doping region (131) is P type.

3. The non-volatile memory cell structure of claim 1 further **characterized in that** said first doping region (131) comprises a first heavily doped region (132) which is in direct contact with said second doping region (135).

4. The non-volatile memory cell structure of claim 3 further **characterized in that** a type of said first heavily doping region (132) is the same as a type of impurity doping into said gate (140).

5. The non-volatile memory cell structure of claim 1 further **characterized in that** said second doping region (135) comprises a second heavily doped region (136) which is in direct contact with said second isolation structure (150).

6. The non-volatile memory cell structure of claim 1 further **characterized in that** a program mechanism is oxide breakdown and a memory state is based on the memory cell receiving the said gate oxide layer (141) rupture process or not.

7. A method for using a non-volatile memory cell **characterized by**:
providing a plurality of non-volatile memory cells, one of said non-volatile memory
cells comprising:
a substrate (110);
a first isolation structure (120) on said substrate (110);
a first doping region (131) disposed on said first isolation structure (120);
a gate (140) disposed on said first doping region (131);
a gate oxide layer (141) sandwiched between said first doping region (131)
and said gate (140);
a second doping region (135) disposed on said first isolation structure (120),
said second doping region (135) being in direct contact with said first doping region (131) and forming a p-n junction with said first doping region (131); and
a second isolation structure (150) disposed on said first isolation structure (120), surrounding said first doping region (131) and said second doping region (135), and said second isolation structure (150) being in direct contact with said first doping region (131) and said second doping region (135), wherein one of said non-volatile memory cells is determined to be a target memory cell; and
programming said target memory cell whose said gate (140) is connected to a
programming voltage (Vpp) and whose said second doping region (135) is connected to 0 volts.

8. The method for using a non-volatile memory cell of claim 7 further **characterized by**:
connecting said gates (140) of said non-volatile memory cells other than said target
memory cell to the voltage smaller than said programming voltage (Vpp); and
connecting said second doping regions (135) of said non-volatile memory cells
other than said target memory cell to the voltage smaller than said programming voltage.

9. The method for using a non-volatile memory cell of claim 7 further **characterized by** programming said target memory cell by breaking down its gate oxide layer (141).

10. The method for using a non-volatile memory cell of claim 7 further **characterized by** determining whether said non-volatile memory cell is to be programmed is done by detecting a current.

11. The method for using a non-volatile memory cell of claim 7 further **characterized by** reading said non-volatile memory cell whose said gate (140) is connected to said
standard voltage (VDD) and whose said second doping region (135) is connected to 0 volts.

12. The method for using a non-volatile memory cell of claim 11 further **characterized by**:
connecting said gates (140) of said non-volatile memory cells other than said target
memory cell to the voltage smaller than said standard voltage (VDD); and
connecting said second doping regions (135) of said non-volatile memory cells to the
voltage smaller than said standard voltage (VDD).
